# EUROPEAN PATENT APPLICATION

(11) **EP 2 687 503 A1**
(43) Date of publication of application: **22.01.2014**
(21) Application number: 13174171.2
(22) Date of filing: 27.06.2013
(51) Int. Cl.: C04B 35/83, B29C 70/48, F16D 65/12, F16D 69/02

(54) **Infiltration of densified carbon-carbon composite material with low viscosity resin**

(30) Priority: 16.07.2012 US 201213550190
(71) Applicant: Honeywell International Inc., Morristown, NJ 07962-2245 (US)
(72) Inventor: La Forest, Mark L., Morristown, NJ New Jersey 07962-2245 (US); Fryska, Slawomir, Morristown, NJ New Jersey 07962-2245 (US)
(74) Representative: Houghton, Mark Phillip

(57) **Abstract**

In one example, a method comprises densifiying a carbonized preform via at least one of resin transfer molding (RTM), vacuum pitch infiltration (VPI) and chemical vapor infiltration/chemical vapor deposition (CVI/CVD), heat treating the densified preform to open internal pores of the densified preform, and infiltrating the internal pores of the densified preform with low viscosity resin to increase the density of the preform.

## Description

### TECHNICAL FIELD

The disclosure relates to carbon-carbon composite materials.

### BACKGROUND

Carbon fiber-reinforced carbon materials, also referred to as carbon-carbon (C-C) composite materials, are composite materials that include carbon fibers reinforced in a matrix of carbon material. The C-C composite materials can be used in many high temperature applications. For example, the aerospace industry employs C-C composite materials as friction materials for commercial and military aircraft, such as brake friction materials.

### SUMMARY

Devices, systems, and techniques for forming a carbon-carbon composite material are described herein. A carbon-carbon composite material resulting from the techniques is also described herein. A carbonized preform which has been densified, e.g., via vacuum pressure infiltration (VPI), resin transfer molding (RTM) and/or chemical vapor deposition (CVD)/chemical vapor infiltration (CVI), may be heat treated to open internal pores of the densified preform. To further densify the preform, low viscosity resin may be infiltrated into the internal pores of the densified preform. By using a relatively low viscosity resin, the resin may penetrate the surface of the preform and fill internal pores more readily than a relatively high viscosity resin, allowing for higher final densities of the C-C composite material resulting from the process. In some examples, the resulting C-C composite material may be used as a friction material, e.g., as an aircraft brake disc.

In one aspect, the disclosure is directed to a method densifiying a carbonized preform via at least one of resin transfer molding (RTM), vacuum pitch infiltration (VPI), and chemical vapor infiltration/chemical vapor deposition (CVI/CVD), heat treating the densified preform to open internal pores of the densified preform, and infiltrating the internal pores of the densified preform with low viscosity resin to increase the density of the preform.

In another aspect, the disclose is directed to a carbon-carbon composite material comprising internal pores filled with a low viscosity resin, wherein the internal pores define a porosity of less than approximately 10 microns, and wherein the low viscosity resin exhibits a viscosity less than approximately 1500 centipoise at room temperature.

The details of one or more examples are set forth in the accompanying drawings and the description below. Other features, objects, and advantages of the disclosure will be apparent from the description and drawings, and from the claims.

### BRIEF DESCRIPTION OF DRAWINGS

FIG. 1 is a schematic block diagram illustrating an example aircraft brake assembly.

FIG. 2 is a flow diagram illustrating an example method of forming a carbon-carbon composite material in accordance with aspects of this disclosure.

### DETAILED DESCRIPTION

Example techniques for forming a carbon-carbon composite material are described herein, along with carbon-carbon composite materials and structures formed using the techniques. A carbonized preform which has been densified, e.g., via VPI, RTM and/or CVD/CVI, may be heat treated to open internal pores of the densified preform. To further densify the preform, low viscosity resin may be infiltrated into the internal pores of the densified preform. By using a relatively low viscosity resin, the resin may penetrate the surface of the preform and fill internal pores more readily than a relatively high viscosity resin, allowing for higher final densities of the C-C composite material resulting from the process. In some examples, the resulting C-C composite material may be used as a friction material, e.g., as an aircraft brake pad.

C-C composite materials used, for example, in aerospace applications such as brake pads, may be formed from carbonized preforms that have been densified using a variety of densification techniques. For example, a carbonized preform may be densified with liquid pitch using VPI and/or RTM. As another example, a carbonized preform may be densified with carbonaceous material using CVD/CVI. The preform may go through multiple cycles of such densification processes to achieve a C-C composite material exhibiting a desired final density. In the case of an aircraft brake pad, in some examples, the carbonized preform may take the form of an annular ring, although other shapes (e.g., non-annular segments) may also be used.

In some examples, following densification of the preform, the resulting C-C material may undergo one or more heat treatment cycles, e.g., to set carbon performance properties (friction, wear, rejected takeoff (RTO), and/or the like). However, such processing may leave open porosity in the final C-C composite material. For example, for preforms subject to pitch densification, the heat treatment may shrink the pitch matrix causing increased open porosity within the material. Such open porosity may be undesirable because it may reduce the final density of the material. For example, in aircraft brake disc applications, the reduced final density may have an undesired influence on RTO effectiveness, wear rates of the brake disc, or both.

In accordance with one or more examples of the disclosure, a C-C composite material may be formed by heat treating a carbonized preform following the densification of a carbonized preform, e.g., via RTM, VPI, and/or CVD/CVI, to open internal pores of the densified preform. Subsequently, a relatively low viscosity resin is infiltrated into the preform to fill the internal pores. The viscosity of the resin may be selected such that the resin is capable of reaching the internal pores of the material opened by the prior heat treatment. For example, the viscosity of the resin may be selected such that the resin penetrates the surface pores to substantially close or at least partially fill sub-surface pores, such as, e.g., those pores approximately half way between opposing outer surface of the C-C composite preform.

By filling the internal pores with such a resin, the final density of the C-C composite material may be increased relative to examples in which the low viscosity resin is not introduced into the internal pores. The increase in final density may provide one or more advantages, such as allowing for the C-C material to act as a better heat sink, e.g., when used as a brake pad, and allowing for better performance of a brake disc formed from the C-C material. Moreover, the difference in density from the outer surface of a component formed from the C-C material to the internal portions of the component (which may be referred to as a density profile) may be reduced as the resin infiltrates into the C-C material of the component to fill the internal pores rather than only filling the surface pores. With such a C-C material, the density of the part may be more consistent and decrease at a lower rate as the surface material wears away, e.g., when used as a brake pad or other friction material.

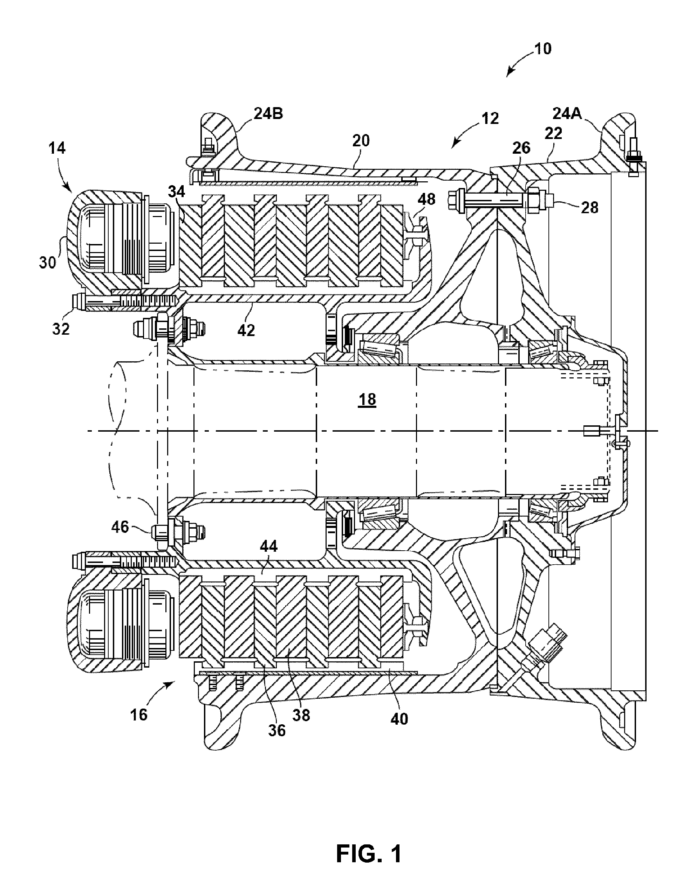

FIG. 1 is a conceptual diagram illustrating an example assembly 10 that may include one or more C-C composite material components formed in accordance with the techniques of this disclosure. For ease of description, examples of the disclosure will be described primarily with regard to aircraft brake discs formed of C-C composite materials. However, the C-C composite materials of this disclosure may be used to form parts other than aircraft brake discs. For example, the C-C composite material may be used a friction material in other types of braking applications, as well as in other applications such as, e.g., heat exchangers and heat shields.

In the example of FIG. 1, aircraft brake assembly 10 includes wheel 12, actuator assembly 14, brake stack 16, and axle 18. Wheel 12 includes wheel hub 20, wheel outrigger flange 22, bead seats 24A and 24B, lug bolt 26, and lug nut 28. Actuator assembly 14 includes actuator housing 30, actuator housing bolt 32, and ram 34. Brake stack 16 includes alternating rotor discs 36 and stator discs 38; rotor discs 36 are configured to move relative to stator discs 38. Rotor discs 36 are mounted to wheel 12, and in particular wheel hub 20, by beam keys 40. Stator discs 38 are mounted to axle 18, and in particular torque tube 42, by splines 44. Wheel assembly 10 may support any variety of private, commercial, or military aircraft.

Wheel assembly 10 includes wheel 18, which in the example of FIG. 1 is defined by a wheel hub 20 and a wheel outrigger flange 22. Wheel outrigger flange 22 is mechanically affixed to wheel hub 20 by lug bolts 26 and lug nuts 28. Wheel 12 defines bead seals 24A and 24B. During assembly, an inflatable tire (not shown) may be placed over wheel hub 20 and secured on an opposite side by wheel outrigger flange 22. Thereafter, lug nuts 28 can be tightened on lug bolts 26, and the inflatable tire can be inflated with bead seals 24A and 24B providing a hermetic seal for the inflatable tire.

Wheel assembly 10 may be mounted to an aircraft via torque tube 42 and axle 18. In the example of FIG. 1, torque tube 42 is affixed to axle 18 by a plurality of bolts 46. Torque tube 42 supports actuator assembly 14 and stators 38. Axle 18 may be mounted on a strut of a landing gear (not shown) to connect wheel assembly 10 to an aircraft.

During operation of the aircraft, braking may be necessary from time to time, such as during landing and taxiing. Accordingly, wheel assembly 10 is configured to provide a braking operation to an aircraft via actuator assembly 14 and brake stack 16. Actuator assembly 14 includes actuator housing 30 and ram 34. Actuator assembly 14 may include different types of actuators such as one or more of, e.g., an electrical-mechanical actuator, a hydraulic actuator, a pneumatic actuator, or the like. During operation, ram 34 may extend away from actuator housing 30 to axially compress brake stack 16 against compression point 48 for braking.

Brake stack 16 includes alternating rotor discs 36 and stator discs 38. Rotor discs 36 are mounted to wheel hub 20 for common rotation by beam keys 40. Stator discs 38 are mounted to torque tube 42 by splines 44. In the example of FIG. 1, brake stack 16 includes four rotors and five stators. However, a different number of rotors and/or stators may be included in brake stack 16. Further, the relative positions of the rotors and stators may be reverse, e.g., such that rotor discs 36 are mounted to torque tube 42 and stator discs 38 are mounted to wheel hub 20.

Rotor discs 36 and stator discs 38 may provide opposing friction surfaces for braking an aircraft. As kinetic energy of a moving aircraft is transferred into thermal energy in brake stack 16, temperatures may rapidly increase in brake stack 16, e.g., beyond 200 degrees Celsius. With some aircraft, emergency braking (e.g., RTO) may result in temperatures in excess of 500 degrees Celsius, and in some cases, even beyond 800 degrees Celsius. As such, rotor discs 36 and stator discs 38 that form brake stack 16 may include robust, thermally stable materials capable of operating at such temperatures. In one example, rotor discs 36 and stator discs 38 are formed of a metal alloy such as, e.g., a super alloy based on Ni, Co, Fe, or the like.

In another example, rotor discs 36 and/or stator discs 38 are formed of a C-C composite material fabricated according to one or more example techniques of this disclosure. In particular, at least one of rotor discs 36 and/or at least one of stator discs 38 may be formed from a carbon-based fiber material formed by infiltrating a densified carbonized preform with low-viscosity pitch to fill open internal pores of the material. As noted above, such techniques may increase the final density of the C-C composite material compared to examples in which the disc is formed from a carbon-based fiber material formed by infiltrating a densified carbonized preform without the low-viscosity pitch infiltration. In addition, the techniques described herein that form a brake disc (or other component) using low-viscosity pitch infiltration of a densified preform may result in a more uniform through thickness density.

Rotor discs 36 and stator discs 38 may be formed of the same materials or different materials. For example, wheel assembly 10 may includes metal rotor discs 36 and C-C composite stator discs 38, or vice versa. Further, each disc of the rotor discs 36 and/or each disc of the stator discs 38 may be formed of the same materials or at least one disc of rotor discs 36 and/or stator discs 38 may be formed of a different material than at least one other disc of the rotor discs 36 and/or stator discs 38.

As briefly noted, in some examples, rotor discs 36 and stator discs 38 may be mounted in wheel assembly 10 by beam keys 40 and splines 44, respectively. In some examples, beam keys 40 may be circumferentially spaced about an inner portion of wheel hub 20. Beam keys 40 may, for example, be shaped with opposing ends (e.g., opposite sides of a rectangular) and may have one end mechanically affixed to an inner portion of wheel hub 20 and an opposite end mechanically affixed to an outer portion of wheel hub 20. Beam keys 40 may be integrally formed with wheel hub 20 or may be separate from and mechanically affixed to wheel hub 20, e.g., to provide a thermal barrier between rotor discs 36 and wheel hub 20. Toward that end, in different examples, wheel assembly 10 may include a heat shield (not shown) that extends out radially and outwardly surrounds brake stack 16, e.g., to limit thermal transfer between brake stack 16 and wheel 12.

In some examples, splines 44 may be circumferentially spaced about an outer portion of torque tube 42. Splines 44 may, for example, be integrally formed with torque tube 42 or may be separate from and mechanically affixed to torque tube 42. In some examples, splines 44 may define lateral grooves in torque tube 42. As such, stator discs 38 may include a plurality of radially inwardly disposed notches configured to be inserted into a spline.

Because beam keys 40 and splines 44 may be in thermal contact with rotor discs 36 and stator discs 38, respectively, beam keys 40 and/or splines 44 may be made of thermally stable materials including, e.g., those materials discussed above with respect to rotor discs 36 and stator discs 38. Accordingly, in some examples, example techniques of the disclosure may be used to form a beam key and/or spline for wheel assembly 10.

The example assembly 10 shown in FIG. 1 is merely one example. In other examples, assembly 10 and the components of assembly 10 (e.g., wheel 10, actuator assembly 14, brake stack 16, and axle 18) may have another suitable configuration.

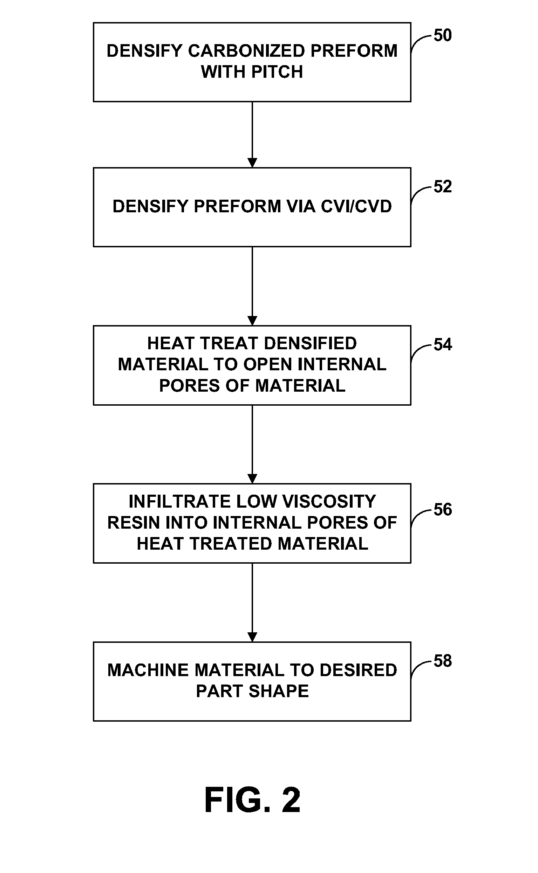

FIG. 2 is a flow diagram illustrating an example technique of forming a C-C composite body in accordance with aspects of the disclosure. It can be desirable to densify the C-C composite body in order improve the thermal conductivity of the body; in some cases, as the density of the C-C composite body increases, the better the body conducts heat, and the better the body acts as a heat sink. In some examples, the C-C composite material from which the C-C composite body is formed may be subjected to a sufficient number of densification steps to result in a final density between about 1.5 grams per cubic centimeter (g/cc) and about 1.9 g/cc such as between about 1.5 g/cc and about 1.85 g/cc.

As shown in FIG. 2, a carbonized preform may be densified with pitch resin (50). Any suitable carbonized preform may be used. In some examples, the carbonized preform may be formed by needling together a plurality of sections of carbon fiber precursor material, such as polyacrylonitrile (PAN) or rayon, and carbonizing the carbon fiber precursor material to form a carbonized preform, e.g., via heat treatment. Alternatively or additionally, the preform may be formed of carbonized materials such as carbonized fabrics formed of carbonized fibers, such as, e.g., carbonized PAN fibers, which may be needled together to form a carbonized preform.

In some examples, the carbonized preform may be densified with liquid pitch resin (50) using one or more cycles of vacuum pressure infiltration (VPI) and/or resin transfer molding (RTM). The pitch may include, for example, at least one of isotropic pitch or mesophase pitch. The pitch may be a high carbon yielding pitch resin. In some examples, the pitch may be at least one of petroleum pitch, coal tar pitch, or synthetic pitch.

In some examples of VPI, the carbon-carbon composite preform is heated under inert conditions to well above the melting point of the impregnating pitch. Thereafter, gas in the pores of the carbon-carbon composite preform is removed by evacuating the preform. Finally, molten pitch is allowed to infiltrate the pores of the preform, as the overall pressure is returned to one atmosphere or above. In the VPI process, a volume of resin or pitch is melted in one vessel while the porous carbon-carbon composite preform is contained in a second vessel under vacuum. The molten resin or pitch is transferred from vessel one into the porous preforms contained in the second vessel using a combination of vacuum and pressure.

In some examples of RTM, the carbon-carbon composite preform is placed into a mold matching the desired part geometry. Typically, a thermoset resin is injected at low temperature (50 °C to 150 °C) using pressure or induced under vacuum, into the porous carbon-carbon composite preform contained within a mold. The resin is cured within the mold before being removed from the mold. US 6,537,470 B1 (Wood et al.) describes a more flexible RTM process that can make use of high viscosity resin or pitch. The entire disclosure of US 6,537,470 B1 is incorporated herein by reference.

Alternatively or additionally, the carbonized preform may be densified with carbonaceous material using chemical vapor deposition (CVD)/chemical vapor infiltration (CVI). In the example of FIG. 2, the carbonized preform densified with pitch (50) is subsequently densified via one or more cycles of CVD/CVI to further densified the material (52). In some examples of CVD/CVI, the carbon-carbon composite preform is heated in a retort under the cover of inert gas, such as at a pressure below 100 torr. When the carbon-carbon composite preform reaches a temperature between about 900 °C and about 1200 °C, the inert gas is replaced with a carbon-bearing gas such as natural gas, methane, ethane, propane, butane, propylene, or acetylene, or a combination of at least two of these gases. When the carbon-bearing gas flows around and through the carbon-carbon composite preform, a complex set of dehydrogenation, condensation, and polymerization reactions occur, thereby depositing the carbon atoms within the interior and onto the surface of the carbon-carbon composite preform. Over time, as more and more of the carbon atoms are deposited onto the surfaces of pores in the carbon-carbon composite preform, the carbon-carbon composite preform becomes more dense. This process may be referred to as densification, because the open spaces in the carbon-carbon composite preform are eventually filled with a carbon matrix until generally solid carbon parts are formed. Depending upon the pressure, temperature, and gas composition, the crystallographic structure and order of the deposited carbon can be controlled, yielding anything from an isotropic carbon to a highly anisotropic, ordered carbon. U.S. Patent Application Publication No. 2006/0046059 (Arico et al.), the entire disclosure of which is incorporated herein by reference, provides an overview of example CVD/CVI processing.

The carbonized preform may undergo one or more cycles of densification (52) (e.g., RTM, VPI, and/or CVD/CVI) until the material exhibits a desired density. For example, such a material may exhibit a density between approximately 1.75 g/cc and approximately 1.90 g/cc. Following the densification of the carbonized preform using such techniques, the resulting material may undergo heat treatment (54). In particular, the densified preform may be subjected to heat treatment to open internal pores within the densified material. For example, the heat treatment may cause the pitch matrix within the densified preform to shrink, thereby opening internal pores and increasing the internal porosity of the densified preform. For example, the heat treatment may open those pores below the surface of the densified preform (which may be referred to as sub-surface pores), such as, e.g., those pores approximately half way between opposing outer surface of the densified preform.

In some examples, the temperature of the heat treatment may be between about 1,000 degrees centigrade and about 2,750 degrees centigrade. Depending on the temperature, the heat treatment may be a single cycle lasting from about two days to about six days, such as, e.g., about three days to about five days.

In general, the heat treatment may serve to increase the internal porosity of the C-C composite body being formed. In some examples, internal pores may exhibit a porosity of about 10 microns or less, e.g., about 1 micron or less, following the heat treatment (54). In some examples, following the heat treatment (54), the internal pores may exhibit a porosity between about 1 micron and about 15 microns. In some examples, the smallest porosity may be the portion of material from the surface to approximately 0.125 inches into the surface of the material.

Following heat treatment, the densified material may be infiltrated with a low-viscosity pitch (56). By opening the internal pores of the material with the heat treatment and using a low-viscosity resin, the resin material may fill the internal pores as a result of the infiltration. The low-viscosity exhibited by the resin may allow the resin to penetrate further and more readily than a resin having a higher viscosity, which may only fill the pores near the surface of the densified material. In some examples, the low-viscosity resin may exhibit a viscosity less than approximately 1,500 centipoise (cP) at room temperature, such as, e.g., a viscosity between approximately 60 cP and approximately 1,500 cP at room temperature, between approximately 250 cP and approximately 1000 cP at room temperature, less than approximately 1000 cP at room temperature, or less than 250 cP at 250 degrees Fahrenheit.

Comparatively, the viscosity of the resins used to densify the carbonized preform via VPI or RTM (50) may exhibit a viscosity greater than 1500 cP such as, e.g., greater than approximately 2000 cP. However, as noted above, in some examples, resins with such viscosities may not readily infiltrate into the internal pores of the densified material but instead may fill only the surface pores of the material due to the relatively low porosity of the material and quinolone insolubles (QI) present following heat treatment (54). Thus, in some examples, the resin introduced into the C-C composite body (56) following the heat treatment may have a lower viscosity than the pitch used to densify the carbonized preform (50).

Any suitable technique may be used to infiltrate the low-viscosity resin into the internal pores of the C-C material (56). For example, VPI or RTM process such as that described above may be utilized to infiltrate (e.g., introduce) the resin into the C-C material. The low viscosity resin may penetrate through the surface pores into the internal portions of the C-C composite body to fill the internal pores. In some examples, the penetration of the resin may be through the entire thickness of the material where there is open porosity. Following the infiltration into the internal pores, the resin may be thermoset, e.g., via a heat treatment.

The low viscosity resin may have any suitable composition that exhibits the desired viscosity. The resin may be, for example, a synthetic pitch resin or a petroleum pitch resin. In some examples, the resin may have a relatively low softening point. For example, the resin may be a petroleum pitch resin or other resin that is a liquid at room temperature. In one example, the low viscosity resin may include furfuryl alcohol, resol resin, and/or epoxy.

By infiltrating the densified material with a low viscosity resin as described herein, the final density of the material may be increased beyond the density material following the described RTM/VPI densification (50) or CVD/CVI densification (52). In some examples, the following RTM/VPI and/or CVD/CVI densification, the material may exhibit a density of less than approximately 1.8 g/cc. However, after that material is heat treated (54) and infiltrated with low viscosity resin, the material may exhibit of final density greater than approximately 1.8 g/cc, such as, e.g., a density between approximately 1.8 g/cc and approximately 1.85 g/cc or a density greater than approximately 1.85 g/cc or greater than 1.90 g/cc. As described above, the increase in final density may allow for the C-C material to act as a better heat sink, e.g., when used as a brake disc.

Following the infiltration of the C-C material with low viscosity resin, the material may be machined to exhibit the desired shape and dimensions of the component the material is being used to form (58). For example, the C-C material may be machined to a size and shape for use in aircraft wheel assembly 10 (FIG. 1), e.g., as rotor discs 36 and/or stator discs 38. However, other application for the material manufacture according to the example techniques described herein are contemplated.

Various examples have been described. These and other examples are within the scope of the following claims.

## Claims

1. A method comprising:
densifiying a carbonized preform via at least one of resin transfer molding (RTM), vacuum pitch infiltration (VPI) and chemical vapor infiltration/chemical vapor deposition (CVI/CVD);
heat treating the densified preform to open internal pores of the densified preform; and
infiltrating the internal pores of the densified preform with low viscosity resin to increase the density of the preform.

2. The method of claim 1, wherein the low viscosity resin exhibits a viscosity less than approximately 1500 centipoise at room temperature.

3. The method of claim 1, wherein the low viscosity resin comprises at least one of a synthetic pitch resin, a petroleum pitch resin, furfuryl alcohol, resol resin, and epoxy.

4. The method of claim 1, wherein heat treating the densified preform comprises heat treating the densified preform at a temperature between approximately 1100 degrees centigrade and 2750 degrees centigrade for at least two days.

5. The method of claim 1, wherein the densified preform exhibits a density greater than approximately 1.8 grams per cubic centimeter after infiltration of the open pores with the low viscosity resin.

6. The method of claim 1, wherein heat treating the densified preform to open internal pores of the densified preform comprises heat treating the densified preform to open the internal pores to define a porosity of less than approximately 10 microns.

7. The method of claim 1, wherein infiltrating the internal pores of the densified preform with low viscosity resin comprises infiltrating the internal pores of the densified preform with low viscosity resin via at least one of RTM and VPI.

8. A carbon-carbon composite material comprising internal pores filled with a low viscosity resin, wherein the internal pores define a porosity of less than approximately 10 microns, and wherein the low viscosity resin exhibits a viscosity less than approximately 1500 centipoise at room temperature.

9. The carbon-carbon composite material of claim 8, wherein the low viscosity resin comprises at least one of a synthetic pitch resin, a petroleum pitch resin, furfuryl alcohol, resol resin, and epoxy.

10. The carbon-carbon composite material of claim 8, wherein the low viscosity resin exhibits a viscosity between approximately 250 centipoise and approximately 1000 centipoise at room temperature.
